# EUROPÄISCHE PATENTSCHRIFT

(11) **EP 1 134 772 B1**
(45) Veröffentlichungstag und Bekanntmachung des Hinweises auf die Patenterteilung: **27.05.2009**
(21) Anmeldenummer: 01104231.4
(22) Anmeldetag: 22.02.2001
(51) Int. Cl.: H01J 37/244, H01J 37/28

(54) **Detektorsystem für ein Korpuskularstrahlgerät und Korpuskularstrahlgerät mit einem solchen Detektorsystem**
Detector system for a corpuscular beam apparatus and corpuscular beam apparatus with such a detector system
Système détecteur pour appareil à faisceau corpusculaire et appareil à faisceau corpusculaire muni d'un tel système détecteur

(30) Priorität: 14.03.2000 DE 10012314
(43) Veröffentlichungstag der Anmeldung: 19.09.2001
(73) Patentinhaber: Carl Zeiss NTS GmbH, 73447 Oberkochen (DE)
(72) Erfinder: Drexel, Volker, 89551 Königsbronn (DE); Benner, Gerd, Dr., 73434 Aalen (DE); Bihr,Johannes, 73431 Aalen (DE); Kujawa, Stephan, Dr., Veldhoven (NL)
(74) Vertreter: Gnatzig, Klaus

(56) Entgegenhaltungen:
- EP-A- 0 721 201
- EP-A- 0 969 495
- US-A- 5 900 629

## Beschreibung

Die vorliegende Erfindung betrifft ein Detektorsystem für ein Korpuskularstrahlgerät und ein Korpuskularstrahlgerät mit einem solchen Detektorsystem.

In Korpuskularstrahlgeräten, wie beispielsweise Rasterelektronenmikroskopen, besteht in der Regel die Aufgabe, zur Bilderzeugung die aus einem Objekt durch Bestrahlung mit einem fokussierten Strahl von Primärkorpuskeln emittierten Korpuskeln zu detektieren. Die vom Objekt emittierten Korpuskeln lassen sich in zwei Gruppen einteilen, die am Objekt durch Streuung zurückgestreuten Korpuskeln und die durch Anregung des Objektes durch den Primärkorpuskelstrahl emittierten Sekundärkorpuskeln. Die am Objekt zurückgestreuten Teilchen oder Korpuskeln weisen dabei nahezu die Energie der Primärkorpuskeln am Objekt auf, während die Sekundärkorpuskeln, beispielsweise die Sekundärelektronen, ein bezogen auf ihre Energie im Bereich einiger eV breites Energiespektrum deutlich unterhalb der Energie der Primärkorpuskeln aufweisen.

Aus der EP 0 661 727-A1 ist ein Rasterelektronenmikroskop mit einer außerachsial im Strahlengang angeordneten Targetstruktur bekannt. Weiterhin sind im Strahlengang ein magnetisches und ein elektrostatisches Ablenkfeld vorgesehen, die jeweils senkrecht zur optischen Achse wirken und senkrecht zueinander stehen und im Sinne eines Wienfilters so zueinander erregt sind, daß die Wirkung des magnetischen Feldes und des elektrostatischen Feldes auf den Primärelektronenstrahl gerade verschwindet. Die sich zu dem Primärelektronenstrahl gerade in entgegengesetzter Richtung ausbreitenden Rückstreuelektronen und Sekundärelektronen werden durch diese Kombination aus magnetischem und elektrostatischem Feld von der optischen Achse des Elektronenmikroskopes weggelenkt, so daß sie auf die Targetstruktur treffen. Die auf die Targetstruktur auftreffenden Teilchen erzeugen wiederum tertiäre Teilchen, Konversionselektronen, die nachfolgend mit Hilfe eines Szintillationsdetektors nachgewiesen werden.

Um bei diesem Detektionssystem nur die zurückgestreuten Elektronen nachzuweisen, kann in Ausbreitungsrichtung der Sekundärelektronen vor dem überlagerten magnetischen und elektrostatischen Feld ein weiteres senkrecht zur optischen Achse stehendes elektrostatisches Feld angelegt werden, durch das verhindert werden soll, daß die Sekundärelektronen überhaupt auf die Koversionselektrode gelangen. Ein solches elektrostatisches Feld senkrecht zur optischen Achse kann man jedoch ohne wesentliche Beeinflussung des Primärstrahles nur dann anlegen, wenn die Sekundärelektronen auch im Bereich dieses Auslenkfeldes eine gegenüber der Energie des Primärstrahles nur sehr geringe Energie aufweisen. Bei Rasterelektronenmikroskopen, bei denen die von der Probe emittierten Teilchen durch eine elektrostatische Linse in das Strahlführungsrohr des Elektronenmikroskopes zurückbeschleunigt werden, wie dieses beispielsweise bei den in der US-A 4 831 266, US-A 4 926 054 und DE-A1 198 28 476.4 beschriebenen Systemen der Fall ist, und auch die Sekundärelektronen aufgrund dieser Beschleunigung im Strahlführungsrohr annähernd die selbe Energie wie die Primärelektronen an dieser Stelle aufweisen, ist eine derartige Unterdrückung der Sekundärelektronen ohne wesentliche Beeinflussung des Primärteilchenstrahles nicht möglich.

In den US-A 5 900 629, US-A 5 872 358 und der bereits erwähnten DE-A1 198 28 476 sind weitere Rasterelektronenmikroskope mit einer Konversionsblende zum indirekten Nachweis der Sekundärelektronen und Rückstreuelektronen beschrieben. Ein separierter Nachweis der Sekundärelektronen und der zurückgestreuten Elektronen wird in diesen Schriften jedoch nicht angesprochen.

In der EP-A1 0 917 178 ist ein weiteres Detektorsystem für ein Rasterelektronenmikroskop beschrieben. Dieses Detektionssystem weist eine Blende auf, die mit einer Szintillationsschicht versehen ist. Die durch Beschuß mit zurückgestreuten Elektronen oder Sekundärelektronen von der Szintillationsschicht emittierten Photonen werden über einen Detektor detektiert. Auch mit diesem System ist keine Trennung des Signals nach Sekundärelektronen und zurückgestreuten Elektronen möglich.

In der EP-A1 0 917 177 ist ein Rasterelektronenmikroskop beschrieben, das zur räumlichen Trennung der Sekundärelektronen von den Primärteilchen eine Folge von magnetischem, elektrostatischem und zweitem magnetischen Ablenkfeld aufweist. Auch hier ist keine Trennung zwischen den von Sekundärelektronen und den von zurückgestreuten Elektronen erzeugten Signalen möglich.

Es ist das Ziel der vorliegenden Erfindung ein Detektionssystem, insbesondere für ein Korpuskularstrahlgerät, anzugeben, mit dem wahlweise die von einem Objekt emittierten Sekundärteilchen oder die am Objekt zurückgestreuten Teilchen detektiert werden können. Dabei soll das Detektionssystem auch dann einsetzbar sein, wenn sich die kinetischen Energien der Primärteilchen, der Sekundärteilchen und der zurückgestreuten Teilchen am Ort der Detektion nur geringfügig voneinander unterscheiden. Dieses Ziel wird erfindungsgemäß durch Detektorsysteme mit den Merkmalen der Ansprüche 1, 2 oder 3 erreicht. Vorteilhafte Ausgestaltungen der Erfindung ergeben sich durch die Merkmale der abhängigen Ansprüche.

Das Detektorsystem nach den Ansprüchen 1, 2 oder 3 weist eine Targetstruktur auf, die in einem zentralen, zur optischen Achse des Korpuskularstrahlgerätes benachbaren, achsennahen Bereich aus einem Elektronen stark konvertierenden Material besteht, der an einem achsenfernen Bereich aufgenommen ist.

Bei einer ersten Ausführungsform der Erfindung ist der achsenferne Bereich gegenüber dem achsennahen Bereich weiter von dem Objekt beabstandet. Bei einer alternativen Ausführungsform der Erfindung ist der achsenferne Bereich als Halbring und der achsennahe Bereich als ein die Enden des Halbringes verbindender Steg ausgebildet. Bei einer dritten Ausführungsform der Erfindung besteht der achsenferne Bereich aus einem nur schwach Elektronen konvertierenden Material.

Das erfindungsgemäße Detektorsystem findet vorzugsweise Anwendung in Kombination mit einem Ablenksystem aus einem elektrostatischen und einem magnetischen Ablenkfeld, deren Feldrichtungen senkrecht zueinander und senkrecht zur optischen Achse des Korpuskularstrahlgerätes stehen. Die beiden zueinander senkrechten Ablenkfelder können dann jeweils so zueinander eingestellt werden, dass sich die Wirkungen beider Ablenkfelder auf den Primärstrahl aufheben, gleichzeitig jedoch die von der Probe emittierten oder zurückgestreuten Teilchen von der optischen Achse des Korpuskularstrahlgerätes weg auf die Targetstruktur lenken. Durch unterschiedlich starke Ablenkfelder können dann die Bedingungen so eingestellt werden, daß nur die Sekundärteilchen auf den Elektronen stark konvertierenden achsennahen Bereich der Targetstruktur auftreffen. In diesem Fall einer relativ schwachen Erregung der Ablenkfelder passieren die am Objekt zurückgestreuten Elektronen wegen ihrer geringfügig höheren Energie im Bereich der optischen Achse die Targetstruktur. Bei einer stärkeren Erregung der beiden Ablenkfelder werden dann auch die am Objekt zurückgestreuten Teilchen auf den achsennahen Bereich der Targetstruktur abgelenkt und treffen auf diesen auf. Bei dieser stärkeren Erregung der Ablenkfelder werden jedoch die Sekundärteilchen bereits so stark von den Ablenkfeldern abgelenkt, daß sie entweder im achsenfernen Bereich aus nur schwach Elektronen konvertierendem Material auf die Targetstruktur auftreffen oder im gegenüber dem achsennahen Bereich weiter zurückliegenden achsenfernen Bereich auf die Targetstruktur auftreffen, und damit in Bereichen, in denen entweder keine tertiär Korpuskeln ausgelöst werden, oder diese im Sinne einer Teilchenfalle von dem für den Nachweis der von der Targetstruktur emittierten Teilchen dienenden Nachweissystem ferngehalten werden.

In allen Ausführungsformen der Erfindung erfolgt die Trennung zwischen Sekundärteilchen und zurückgestreuten Teilchen durch eine strenge räumliche Begrenzung des Detektionsbereiches der Targetstruktur in einer Richtung senkrecht zur optischen Achse des Korpuskularstrahlgerätes. Die Abmessungen des zentralen, achsennahen Bereiches der Targetstruktur einerseits und der Abstand der Targetstruktur von der optischen Achse sind dabei so gewählt, daß entweder nur die Sekundärteilchen oder nur die am Objekt zurückgestreuten Teilchen auf den konvertierenden Bereich der Targetstruktur auftreffen können. Der achsennahe Bereich der Targetstruktur ist dazu stegförmig mit der schmalen Stegseite parallel zur Richtung des elektrostatischen Ablenkfeldes oder als ein schmaler Ring oder Ausschnitt eines schmalen Ringes ausgebildet. Die Stegbreite oder Ringbreite ist dabei entsprechend der gewünschten Energieauflösung gewählt.

Bei einem vorteilhaften Ausführungsbeispiel der Erfindung sind das elektrostatische Ablenkfeld und das magnetische Ablenkfeld in Richtung der optischen Achse des Korpuskularstrahlgerätes zueinander versetzt angeordnet.

Bei einem weiterhin vorteilhaften Ausführungsbeispiel sind zwei magnetische Ablenkfelder und ein elektrostatisches Ablenkfeld vorgesehen. Durch diese Kombination von insgesamt drei Feldern kann das Ablenksystem gleichzeitig auch zur Justierung des Primärteilchenstrahles auf die optische Achse des Objektivs dienen.

Das elektrostatische Feld und das magnetische Feld sollten vorzugsweise unabhängig voneinander einstellbar sein, so daß der nötige Freiheitsgrad für eine Justierung des Primärelektronenstrahles relativ zur optischen Achse des Korpuskularstrahlgerätes gewährleistet ist.

Zum Nachweis der von der Targetstruktur emittierten Teilchen ist natürlich ein Nachweissystem vorzusehen. Dieser liegt vorzugsweise auf einem gegenüber der Targetstruktur positiven Potential, so daß die von der Targetstruktur emittierten Teilchen in Richtung auf das Nachweissystem beschleunigt werden.

Dem Nachweissystem ist vorzugsweise eine Elektrode, beispielsweise eine Gitterelektrode oder eine Lochblende vorgeschaltet. Diese Elektrode, die gegenüber der Targetstruktur auf einem positiven Potential liegen sollte, kann dabei eine Doppelfunktion erfüllen, nämlich einerseits zum Absaugen der von der Targetstruktur emittierten Teilchen dienen und gleichzeitig zur Erzeugung des elektrostatischen Ablenkfeldes dienen.

Alternativ ist auch eine Lochblende auf dem Potential der Targetstruktur mit einem dahinter angeordneten Detektor, der gegenüber der Targetstruktur und der Lochblende auf einem positiven Potential liegt, möglich. Das zwischen dem Detektor und der Lochblende erzeugte elektrostatische Feld greift dann durch die Lochblende hindurch und dieser Durchgriff bildet dann das elektrostatische Ablenkfeld, das gleichzeitig auch zum Absaugen der von der Targetstruktur emittierten Teilchen dient.

Da die Konversionselektronen mit einer gegenüber dem Primärstrahl geringen Energie aus der Targetstruktur austreten, ist bereits mit einem recht schwachen elektrostatischen Absaugfeld eine effiziente Absaugung der Konversionselektronen gewährleistet.

Nachfolgend werden Einzelheiten der Erfindung anhand der in den Figuren dargestellten Ausführungsbeispiele näher erläutert. Im einzelnen zeigen:
- Figur 1: den Schnitt durch ein Rasterelektronenmikroskop mit einem erfindungsgemäßen Detektorsystem,
- Figur 2: einen vergrößerten Teilausschnitt eines Rasterelektronenmikroskops mit einem erfindungsgemäßen Detektorsystem gemäß Figur 1,
- Figur 3: einen vergrößerten Teilausschnitt eines Rasterelektronenmikroskops mit einem erfindungsgemäßen Detektorsystem eines weiteren Ausführungsbeispieles,
- Figur 4: die Aufsicht auf eine blendenförmige Targetstruktur aus stark konvertierendem und schwach konvertierendem Material, und
- Figur 5: die Aufsicht auf eine Targetstruktur mit einem stegförmigen Elektronen konvertierenden Bereich.

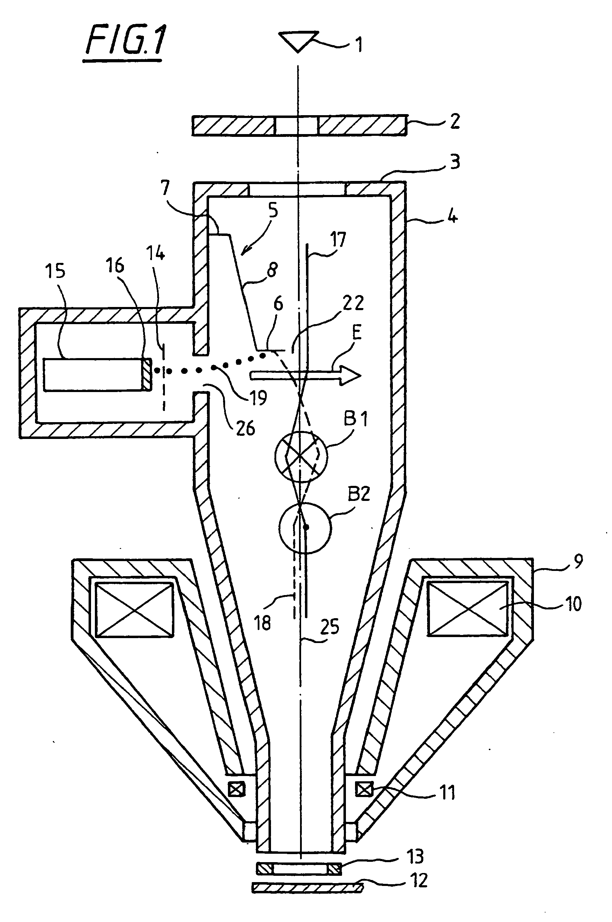

Das in der Figur 1 dargestellte Rasterelektronenmikroskop hat im Grundsatz einen Aufbau, der dem Rasterelektronenmikroskop in der DE-A1 198 28 476 entspricht. Der Teilchenstrahlerzeuger besteht aus einer Teilchen emittierenden Kathode (1), einer Extraktionselektrode (2) und einer Anode (3). Ist das Korpuskularstrahlgerät als Rasterelektronenmikroskop ausgebildet, ist die Kathode (1) vorzugsweise ein thermischer Feldemitter. Die aus der Kathode (1) austretenden Teilchen werden durch die in der Figur 1 nicht dargestellte Potentialdifferenz zwischen der Kathode (1) und der Anode (3) auf das Anodenpotential beschleunigt.

Die Anode (3) bildet gleichzeitig das quellenseitige Ende des Strahlführungsrohres (4). Dieses Strahlführungsrohr (4) aus elektrisch leitendem Material ist durch die Bohrung durch die Polschuhe (9) einer als Objektiv wirkenden Magnetlinse mit einer ringförmigen Magnetspule (10) geführt und ist am objektseitigen Ende als Rohrelektrode ausgebildet. Dem Strahführungsrohr nachgeordnet ist eine Einzelelektrode (13), die gemeinsam mit der Rohrelektrode des Strahlführungsrohres eine elektrostatische Verzögerungseinrichtung bildet. Die Rohrelektrode liegt gemeinsam mit dem gesamten Strahlführungsrohr auf dem Anodenpotential, während die Einzelelektrode (13) und die Probe (12) auf einem gegenüber dem Anodenpotential niedrigeren Potential liegen, so daß die Teilchen nach Austritt aus dem Strahlführungsrohr auf die gewünschte niedrigere Energie abgebremst werden.

In der Bohrung des Polschuhs (9) der Objektivlinse in Höhe des Polschuhspaltes ist noch ein Ablenksystem (11) angeordnet, durch das der durch das Objektiv (9) auf die Probe (12) fokussierte Primärelektronenstrahl senkrecht zu der strichpunktiert dargestellten optischen Achse (25) zum Abrastern der Probe (12) abgelenkt wird.

Alternativ zu der Darstellung in Figur 1 kann das Strahlführungsrohr (4) auch auf der Höhe des Polschuhspaltes des Polschuhs (9) enden und die Abbremselektrode (13) auch in etwa in Höhe des Polschuhspaltes angeordnet sein. Die Abbremsung der Primärteilchen auf die gewünschte Auftreffenergie erfolgt dann bereits innerhalb des Objektivs, so daß sich das magnetische Feld der Objektivlinse und das elektrostatische Verzögerungsfeld räumlich überlagern.

Zwischen der Anode (3) und dem Objektiv (9) ist innerhalb des Strahlführungsrohres ein Mehrfach-Ablenksystem angeordnet, das aus zwei seriell hintereinander geschalteten magnetischen Dipolfeldern (B1, B2) und einem weiteren transversalen elektrischen Feld (E) besteht. Die Feldrichtungen sowohl beider magnetischer Dipolfelder (B1, B2) und des transversalen elektrischen Dipolfeldes (E) sind sämtlich senkrecht zur optischen Achse (25) ausgerichtet, wobei wiederum die Feldrichtungen der beiden magnetischen Dipolfelder (B1, B2) senkrecht zur Feldrichtung des elektrostatischen Dipolfeldes (E) ist. Bei dem in der Figur 1 dargestellten Ausführungsbeispiel sind weiterhin die beiden magnetischen Dipolfelder antiparallel zueinander und folgen aufeinander. Die Feldstärken aller drei Dipolfelder (B1, B2, E) sind unabhängig voneinander einstellbar. Der elektrostatische Dipol ist dabei quellenseitig der magnetischen Dipole angeordnet.

Zwischen der Anode (3) und dem elektrostatischen Dipolfeld (E) ist weiterhin das erfindungsgemäße Detektorsystem (5) angeordnet. Dieses Detektorsystem weist im wesentlichen eine Targetstruktur auf, die einseitig von der optischen Achse angeordnet ist und im Schnitt im wesentlichen Z-förmig ist. Die Targetstruktur (5) hat einen von der optischen Achse (25) in radialer Richtung entfernten Bereich (7), an dem die Targetstruktur innerhalb des Strahlführungsrohres (4) aufgenommen ist. In einem Zwischenbereich (8) ist die Targetstruktur als Konos-Stück ausgebildet, so daß in diesem Zwischenbereich (8) die Schnittflächen der Targetstruktur in einer die optische Achse enthaltenden Ebene entweder parallel zur optischen Achse oder geneigt zur optischen Achse verlaufen, wobei die Neigung so gewählt ist, daß der Abstand der Targetstruktur von der optischen Achse (25) in Ausbreitungsrichtung des Primärelektronenstrahls geringer wird. Am Ende des Zwischenbereiches (8) weist die Targetstruktur einen Abstand (22) zur optischen Achse (25) für den Durchtritt der Primärelektronen auf. Weiterhin weist die Targetstruktur (5) einen zentralen, zur optischen Achse (25) benachbarten Bereich (6) aus Elektronen konvertierendem Material auf, also aus Material, das bei Beschuß mit Teilchen mit relativ hohem Wirkungsgrad Konversionslelektronen emittiert. Als Materialien für diesen Elektronen konvertierenden Bereich kommen Metalle mit hoher Ordnungszahl wie Gold, Kupfer und Platin in Frage. Die Oberfläche in diesem zur optischen Achse benachbarten Bereich steht dabei senkrecht zur optischen Achse (25). Die Targetstruktur liegt auf dem Potential des Strahlführungsrohres. Die von der Targetstruktur emittierten Konversionslektronen sind über ein geeignetes Nachweissystem nachweisbar. Als Nachweissystem dient dabei bei dem in Figur 1 dargestellten Ausführungsbeispiel ein Photomultiplier (15) mit einem vorgeschalteten Szintillator (16). Das Nachweissystem liegt gegenüber dem Strahlführungsrohr auf einem positiven Potential.

Der Abstand zwischen der der optischen Achse (25) zugewandten Kante des Elektronen konvertierenden Bereiches (6) der Targetstruktur (5) und der optischen Achse beträgt etwa 0,2 - 3 mm. Das Nachweissystem (14, 15, 16) selbst ist außerhalb des Strahlführungsrohres (4) hinter einem Loch (26) durch die Wandung des Strahlführungsrohres (4) angeordnet.

Die Lage des Loches (26) ist dabei so gewählt, daß das Loch (26) in Ausbreitungsrichtung der Sekundärelektronen und der Rückstreuelektronen unmittelbar vor der Ebene des Elektronen konvertierenden Bereiches (6) liegt, der quellenseitige Rand des Loches (26) also mit der Ebene des Elektronen konvertierenden Bereiches zusammen fällt. Der Durchmesser des Loches bzw. dessen Kantenlänge beträgt dabei 2 - 8 mm.

Weiterhin weist das Nachweissystem eine Elektrode (14) auf, die entweder als Gitterelektrode oder als Lochelektrode ausgebildet ist und gegenüber dem Strahlführungsrohr (4) auf einem positiven Potential liegt. Diese Elektrode (14) bildet dabei einerseits ein elektrostatisches Absaugfeld für die vom Elektronen konvertierenden Bereich (6) der Targetstruktur (5) emittierten Konversionselektronen, und gleichzeitig erzeugt diese Elektrode gemeinsam mit dem Strahlführungsrohr (4) das elektrostatische Dipolfeld (E). Die Gitterelektrode (14) liegt dabei zwischen +10V und +1000V gegenüber dem Strahlführungsrohr (4) und der Targetstruktur (5). Der Szintillator (16) gemeinsam mit dem Photomultiplier (15) liegen auf +8kV bis +12kV gegenüber der Gitterelektrode (14). Das zwischen der Gitterelektrode (14) und dem Strahlführungsrohr (4) gebildete Dipolfeld greift dabei durch das Loch (26) des Strahlführungsrohres (4) hindurch, wodurch erreicht wird, daß das elektrostatische Dipolfeld (E) innerhalb des Strahlführungsrohres (4) stark lokalisiert ist und Konversionselektronen, die andernorts als im Elektronen konvertierenden Bereich (6) erzeugt werden, nicht zum Nachweissystem (15, 16) hin abgesaugt werden.

Die serielle Anordnung des elektrostatischen Dipolfeldes (E) und der beiden weiteren magnetischen Dipolfelder (B1, B2) erfüllen bei der vorliegenden Anordnung eine Doppelfunktion: Einerseits dienen diese Dipolfelder zur Trennung der von der Probe (12) emittierten Sekundärelektronen und Rückstreuelektronen vom Primärelektronenstrahl und gleichzeitig dienen diese Dipolfelder um den Primärelektronenstrahl relativ zur optischen Achse (25), die durch die optische Achse des Objektivs (9, 10) definiert ist, zu justieren. Ein in das elektrostatische Dipolfeld (E) eintretender Primärelektronenstrahl (17) (in Figur 1 als durchgezogene Linie dargestellt) wird dazu durch das elektrostatische Dipolfeld (E) zunächst abgelenkt, vom ersten magnetischen Dipolfeld (B1) zu der durch das Objektiv (9, 10) definierten optischen Achse (25) zurückgelenkt und durch das zweite magnetische Dipolfeld (B2) richtungsmäßig so umgelenkt, daß der Primärelektronenstrahl nach Austritt aus dem zweiten magnetischen Dipolfeld (B2) auf der optischen Achse (25) des Objektivs (9) verläuft.

Die durch Beschuß mit den Primärteilchen aus der Probe (12) ausgelösten Sekundärelektronen und die an der Probe (12) zurückgestreuten Primärelektronen (Rückstreuelektronen) werden durch die Potentialdifferenz zwischen dem Strahlführungsrohr (4) und der Elektrode (13) in das Strahlführungsrohr (4) zurückbeschleunigt. Da bei zahlreichen Anwendungen sowohl in der Biologie als auch bei Halbleiteruntersuchungen die Energie der Primärelektronen im Bereich der Probe (12) wesentlich geringer als die Energie der Primärelektronen innerhalb des Strahlführungsrohres (4) ist, weisen sowohl die Sekundärelektronen als auch die an der Probe (12) zurückgestreuten Elektronen innerhalb des Strahlführungsrohres (4) eine Energie auf, die nahezu der Energie der Primärelektronen entspricht. Die Energie der Rückstreuelektronen ist dabei nach wie vor geringfügig höher als die Energie der Sekundärelektronen. Bei einer Potentialdifferenz von beispielsweise 15kV zwischen der Kathode (1) und der Anode (3) und einer Potentialdifferenz von 1kV zwischen der Kathode (1) und der Abbremselektrode (13) haben die Primärelektronen innerhalb des Strahlführungsrohres (4) eine Energie von 16 keV und werden zwischen dem Austritt aus dem Strahlführungsrohr (4) und der Abbremselektrode (13) auf 1keV abgebremst. Die Primärelektronen treffen dann mit einer Energie von 1 keV auf die Probe (12) auf. Die an der Probe (12) zurückgestreuten Elektronen erfahren nur einen geringfügigen Energieverlust und werden demzufolge zwischen der Abbremselektrode (13) und dem Wiedereintritt ins Strahlführungsrohr (4) auf nahezu 16 keV beschleunigt. Die aus der Probe (12) austretenden Sekundärelektronen weisen dem gegenüber nur eine sehr geringe kinetische Energie von wenigen Elektronenvolt auf, werden dann jedoch zwischen der Abbremselektrode (13) und dem Wiedereintritt ins Strahlführungsrohr (4) auf eine Energie von etwa 15 keV beschleunigt.

Der weitere Verlauf der Sekundärelektronen innerhalb des Strahlführungsrohres (4) ist in der Figur 1 gestrichelt als Bahnverlauf (18) dargestellt. Die Sekundärelektronen erfahren aufgrund ihrer zu den Primärelektronen (17) entgegengesetzten Bewegungsrichtung in den beiden magnetischen Dipolfeldern (B1, B2) eine Ablenkung, die zu der jeweiligen Ablenkung des Primärelektronenstrahles (17) entgegengesetzt ist. Da jedoch die Kraftrichtung des elektrostatischen Dipolfeldes (E) unabhängig von der Bewegungsrichtung ist und die Sekundär- und Rückstreuelektronen unter zum Primärstrahl entgegengesetzter Neigung in das elektrostatische Dipolfeld eintreten, erfolgt durch das elektrostatische Dipolfeld (E) eine Separierung der Sekundärelektronen und der Rückstreuelektronen vom Bahnverlauf der Primärelektronen. Diese zurücklaufenden Elektronen werden durch das elektrostatische Dipolfeld (E) auf den Elektronen konvertierenden Bereich (6) der Targetstruktur (5) abgelenkt und erzeugen Konversionselektronen, die von der Gitterelektrode (14) und dem dadurch erzeugten Potential zum Nachweissystem (15, 16) abgesaugt werden. Diese Konversionselektronen sind in der Figur 1 punktiert angedeutet und mit dem Bezugszeichen (19) versehen.

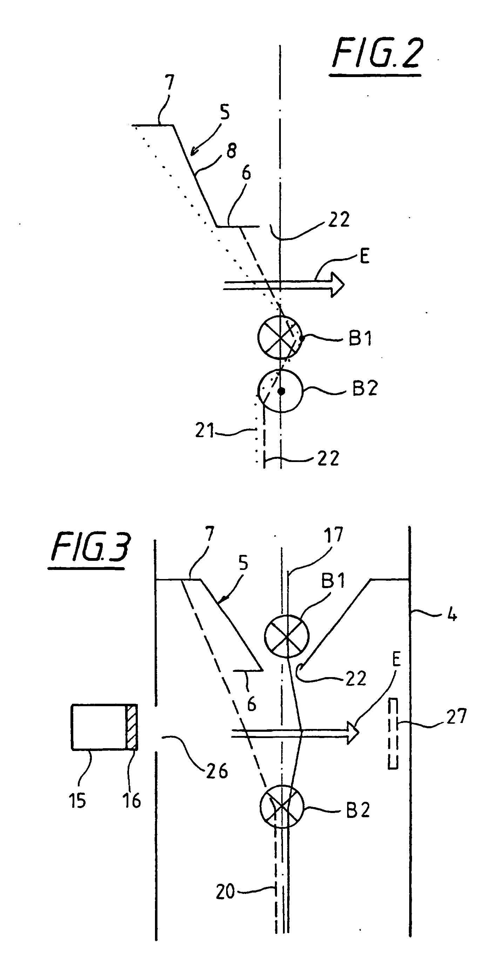

Die Separierung zwischen Rückstreuelektronen und Sekundärelektronen bei der Anordnung nach Figur 1 ist anhand der Figur 2 näher erläutert. Dabei sind in der Figur 2 die Rückstreuelektronen als gestrichelte Linie (20) und die Sekundärelektronen als punktierte Linie (21) angedeutet. Aufgrund ihrer geringeren kinetischen Energie erfahren die Sekundärelektronen innerhalb der magnetischen Dipolfelder (B1, B2) eine stärkere Umlenkung als die zurückgestreuten Elektronen (20). Die Wirkung des elektrostatischen Dipolfeldes ist demhingegen auf die zurückgestreuten Elektronen und die Sekundärelektronen identisch. Je nach Erregung der beiden magnetischen Dipolfelder ist demzufolge die Umlenkung, die die zurückgestreuten Elektronen (20) und die Sekundärelektronen (21) erfahren, unterschiedlich. Bei relativ starker Erregung der beiden magnetischen Dipolfelder (B1, B2) wird erreicht, daß die zurückgestreuten Elektronen auf den Elektronen konvertierenden Bereich (6) der Targetstruktur (5) auftreffen. Aufgrund ihrer stärkeren Ablenkung passieren demhingegen die Sekundärelektronen den Elektronen konvertierenden Bereich (6) und treffen im peripheren Bereich (7) auf die Targetstruktur (5). Da dieser periphere Bereich (7) nicht Elektronen konvertierend ist oder, soweit doch Konversionselektronen im geringen Umfange auftreten, durch das in diesem Bereich nicht vorhandene elektrostatische Absaugfeld nicht das Nachweissystem erreichen, werden bei dieser Einstellung der magnetischen Dipolfelder (B1, B2) ausschließlich Konversionselektronen nachgewiesen, die von zurückgestreuten Elektronen ausgelöst worden sind.

Bei einer schwächeren Erregung der magnetischen Dipolfelder (B1 B2) und einer daraus resultierenden schwächeren Ablenkung der Sekundärelektronen und der Rückstreuelektronen kann erreicht werden, daß die Sekundärelektronen (21) auf den Elektronen konvertierenden Bereich (6) der Targetstruktur (5) auftreffen. Aufgrund der schwächeren Ablenkung der zurückgestreuten Elektronen passieren diese dann jedoch die Targetstruktur im achsennächsten Bereich (22), so daß in diesem Fall nur Konversionselektronen nachgewiesen werden, die von Sekundärelektronen ausgelöst worden sind.

Das in der Figur 3 dargestellte Ausführungsbeispiel unterscheidet sich von dem in der Figur 1 dargestellten Ausführungsbeispiel nur in dem dargestellten Bereich und entspricht ansonsten dem Ausführungsbeispiel nach Figur 1. Bei diesem Ausführungsbeispiel ist einerseits die Reihenfolge der drei Dipolfelder vertauscht, wobei beim Ausführungsbeispiel nach Figur 3 das elektrostatische Dipolfeld zwischen den beiden magnetischen Dipolfeldern (B1, B2) erzeugt ist. Die räumliche Lage des elektrostatischen Ablenkfeldes (E) in Bezug auf die Lage der Targetstruktur entspricht dabei der Lage im Ausführungsbeispiel nach Figur 1. Dadurch liegt das in Ausbreitungsrichtung des Primärelektronenstrahls erste magnetische Dipolfeld in Ausbreitungsrichtung des Primärelektronenstrahls gesehen vor oder auf der Höhe der Targetstruktur (5). Gleichzeitig sind bei diesem Ausführungsbeispiel die beiden magnetischen Dipolfelder parallel zueinander ausgerichtet. Die Trennung zwischen Sekundärelektronen und zurückgestreuten Elektronen erfolgt bei diesem Ausführungsbeispiel völlig analog zu dem zuvor beschriebenen Ausführungsbeispiel. Allerdings ist bei diesem Ausführungsbeispiel die Trennung zwischen Sekundärelektronen und Rückstreuelektronen gegenüber dem Ausführungsbeispiel nach Figuren 1 und 2 deutlich verstärkt, da die energieabhängige Umlenkung innerhalb der magnetischen Dipolfelder aufgrund der parallelen Ausrichtung der beiden magnetischen Dipolfelder (B1, B2) verstärkt ist.

Als weiterer Unterschied zum Ausführungsbeispiel nach Figur 1 ist beim Ausführungsbeispiel nach Figur 3 auf die Gitterlelektrode (14) verzichtet. Die Elektroden für das elektrostatische Ablenkfeld werden dadurch unmittelbar durch den Szintillationsdetektor (15, 16) und die Außenwand des Strahlführungsrohres (4) gebildet und das zwischen diesen Elektroden gebildete Feld greift wiederum durch das Loch (26) des Strahlführungsrohres hindurch. Dieser weitere Unterschied ist jedoch nicht zwangsweise mit der geänderten Reihenfolge der Ablenkfelder verknüpft. Vielmehr ist es auch denkbar, auch bei der Reihenfolge der Ablenkfelder entsprechend dem Ausführungsbeispiel nach Figur 3 zusätzlich eine Gitterlelektrode zwischen dem Szintillationsdetektor (15, 16) und dem Loch durch das Strahlführungsrohr vorzusehen, oder bei der Reihenfolge der Ablenkfelder entsprechend dem Ausführungsbeispiel nach Figur (1) auf die Gitterelektrode (14) zu verzichten. Des weiteren kann bei beiden Ausführungsformen auch noch eine zusätzliche Elektrode (27) innerhalb des Strahlführungsrohres, die der positiven Absaugelektrode in Bezug auf die optische Achse (25) gegenüber steht, vorteilhaft sein. Eine solche zusätzliche Elektrode (27) ist in Figur 3 gestrichelt angedeutet.

Bei den anhand der Figuren 1 - 3 beschriebenen Ausführungsbeispielen ist die Tagetstruktur (5) jeweils mit einem Z-förmigen Querschnitt ausgebildet. Dadurch wird im peripheren, von der optischen Achse beabstandeten Bereich der Targetstruktur eine Elektronenfalle gebildet, die verhindert, daß in dem von der optischen Achse beabstandeten Bereich (7) der Targetstruktur (5) erzeugte Konversionselektronen das Nachweissystem erreichen. Damit eine wirksame Trennung zwischen den von den Rückstreuelektronen erzeugten Signalen und den von Sekundärelektronen erzeugten Signalen möglich ist, sollte der Abstand in Richtung der optischen Achse zwischen dem von der optischen Achse beabstandeten Bereich und dem achsennahen, Elektronen konvertierenden Bereich (6) so groß gewählt sein, daß im achsenfernen Bereich (7) das elektrostatische Absaugfeld nicht oder kaum noch nachweisbar ist, so daß eventuell in diesem Bereich erzeugte Konversionselektronen nicht nachgewiesen werden. Je nach Geometrie des Strahlführungsrohres reichen dafür jedoch Abstände von 1mm oder größer in Richtung der optischen Achse aus.

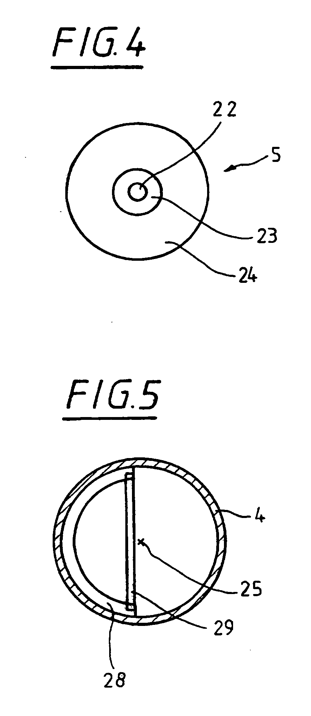

Bei dem in der Figur 4 dargestellten Ausführungsbeispiel ist demhingegen die Targetstruktur als Blende (5) eben ausgebildet. Diese Blende (5) hat im Zentrum die Blendenöffnung (22) und daran in radialer Richtung anschließend einen Elektronen konvertierenden Bereich (23), der aus einem Elektronen konvertierenden Material besteht. Im peripheren Bereich (24) besteht die Blende (5) aus einem Elektronen nicht konvertierenden Material. Da jedoch grundsätzlich jedes Material - wenn auch mit unterschiedlichen Wirkungsgraden - beim Beschuß mit hochenergetischen Elektronen Konversionselektronen erzeugt, ist mit einer derartigen ebenen Blende nur eine schlechtere Trennung der von Rückstreuelektronen erzeugten Signale und der von Sekundärelektronen erzeugten Signale möglich.

Die in der Figur 5 dargestellten Ausführungsform für eine Targetstruktur weist einen als Halbring (28) ausgebildeten Träger auf, an dem die Targetstruktur am Strahlführungsrohr (5) aufgenommen ist. Die beiden Enden des Trägers (28) sind durch einen Steg (29) aus Elektronen stark konvertierendem Material miteinander Verbunden. Bei dieser Ausführungsform werden nur von dem Teil der zurückgestreuten Elektronen oder Sekundärelektronen Konversionselektronen erzeugt und nachgewiesen, die auf den Steg (29) auftreffen.

Die Breite des achsennahen, Elektronen konvertierenden Bereiches (6, 29) und dessen Abstand von der optischen Achse (25) sind natürlich in Abhängigkeit von den übrigen Konstruktionsparametem des Elektronenmikroskopes und der gewünschten Energieauflösung derart auszulegen, daß entweder nur die Sekundärelektronen oder nur die Rückstreuelektronen, oder sogar jeweils nur ein ausgewählter Teil davon, auf den Elektronen konvertierenden Bereich (6, 29) auftreffen.

Das erfindungsgemäße Detektorsystem kann auch in einem Bereich des Elektronenmikroskopes angeordnet werden, in dem ohnehin eine Blende, beispielsweise eine Druckstufenblende erforderlich ist. In diesem Fall kann die Targetstruktur als ebene oder konische Blende ausgebildet sein und gleichzeitig die Funktion einer Druckstufenblende übernehmen.

Bei den anhand der Figuren 1 und 3 dargestellten Ausführungsbeispielen wird als Nachweissystem für die Konversionselektronen ein Szintillationsdetektor bestehend aus einem Photomultiplier mit einer vorgeschalteten Szintillationsschicht eingesetzt. Es ist jedoch auch möglich, anstelle des Photomultipliers mit vorgeschalteter Szintillationsschicht eine vollflächige Elektrode vorzusehen. Der Nachweis der Konversionselektronen kann dann einfach über den Elektrodenstrom gegebenenfalls mit geeigneter Verstärkung erfolgen.

Bei den anhand der Figuren beschriebenen Ausführungsbeispielen sind das elektrostatische und die beiden magnetischen Dipolfelder jeweils entlang der optischen Achse versetzt zueinander angeordnet. Für die Trennung der Sekundärelektronen und der Rückstreuelektronen voneinander und der Ablenkung sowohl der Sekundärelektronen und der Rückstreuelektronen von der optischen Achse reicht jedoch grundsätzlich ein einziges elektrostatisches Dipolfeld und ein einziges magnetisches Dipolfeld aus. Diese beiden Felder können auch noch im Sinne eines Wienfilters einander überlagert sein. Allerdings besteht bei dieser vereinfachten Ausführungsform nicht mehr die Möglichkeit, den einfallenden Primärelektronenstrahl relativ zu der durch das Objektiv (9) definierten optischen Achse (9) zu justieren.

Bei den anhand der Figuren 1 und 3 beschriebenen Ausführungsbeispielen ist das Nachweissystem jeweils hinter einem Loch durch das Strahlführungsrohres (5) angeordnet. Alternativ kann das Strahlführungsrohr in diesem Bereich auch ganz unterbrochen sein, so daß das Strahlführungsrohr aus zwei Teilrohren besteht, die in Richtung der optischen Achse (25) voneinander beabstandet sind.

## Patentansprüche

1. Detektorsystem für ein Korpuskularstrahlgerät, insbesondere Rasterelektronenmikroskop, mit einer im Strahlengang anzuordnenden Targetstruktur (5), wobei die Targetstruktur (5) einen zentralen, zur optischen Achse (25) des Korpuskularstrahlgerätes benachbarten achsennahen Bereich (6, 23, 29) aus einem Elektronen stark konvertierenden Material und einen achsenfernen Bereich (7, 24, 28) aufweist, und einem Nachweissystem (14, 15, 16) zum Nachweis der von dem Elektronen konvertierenden Bereich (6, 23, 29) emittierten Konversionselektronen, **dadurch gekennzeichnet, dass** der achsenferne Bereich (28) als Halbring und der achsennahe Bereich (29) als die Enden des halbringförmigen achsenfernen Bereiches (28) verbindender Steg ausgebildet sind.

2. Detektorsystem für ein Korpuskularstrahlgerät, insbesondere Rasterelektronenmikroskop, mit einer im Strahlengang anzuordnenden Targetstruktur (5), wobei die Targetstruktur (5) einen zentralen, zur optischen Achse (25) des Korpuskularstrahlgerätes benachbarten achsennahen Bereich (6, 23, 29) aus einem Elektronen stark konvertierenden Material und einen achsenfernen Bereich (7, 24, 28) aufweist, und einem Nachweissystem (14, 15, 16) zum Nachweis der von dem Elektronen konvertierenden Bereich (6, 23, 29) emittierten Konversionselektronen, wobei die Targetstruktur (5) als ebene Blende ausgebildet ist **dadurch gekennzeichnet, dass** der achsenferne Bereich (24) aus einem Elektronen schwach konvertierenden Material besteht.

3. Detektorsystem für ein Korpuskularstrahlgerät, insbesondere Rasterelektronenmikroskop, mit einer im Strahlengang anzuordnenden, zusammenhängenden Targetstruktur (5), wobei die Targetstruktur (5) einen zentralen, zur optischen Achse (25) des Korpuskularstrahlgerätes benachbarten achsennahen Bereich (6, 23, 29) aus einem Elektronen stark konvertierenden Material aufweist der über einen Zwischenbereich an, einem achsenfernen Bereich (7, 24, 28) angeordnet ist, und einen Nachweissystem (14, 15, 16) zum Nachweis der von dem Elektronen konvertierenden Bereich (6, 23, 29) emittierten Konversionselektronen wobei, der achsenferne Bereich (7) gegenüber dem achsennahen Bereich in Richtung der optischen Achse (25) beabstandet ist.

4. Korpuskularstrahlgerät mit einem Detektorsystem nach einem der Ansprüche 1 - 3.

5. Korpuskularsirahlgerät nach Anspruch 4, wobei dem Detektorsystem (5, 6, 7, 8) in Richtung der aus einem Präparat (12) austretenden Korpuskeln ein Ablenksystem aus einem elektrostatischen Ablenkfeld (E) und einem magnetischen Ablenkfeld (B1, B2) vorgeschaltet ist, wobei das elektrostatische Ablenkfeld (E) und das magnetische Ablenkfeld (B1, B2) senkrecht zueinander ausgerichtet sind.

6. Korpuskularstrahlgerät nach Anspruch 5, wobei das elektrostatische Ablenkfeld (E) und das magnetische Ablenkfeld (B 1, B2) in Richtung der optischen Achse (25) des Korpuskularstrahlgerätes versetzt zueinander erzeugt sind.

7. Korpuskularstrahlgerät nach Anspruch 6, wobei zwei magnetische Ablenkfelder (B1, B2) und ein elektrostatisches Ablenkfeld (E) vorgesehen sind.

8. Korpuskularstrahlgerät nach einem der Ansprüche 5 - 7, wobei das Nachweissystem (14, 15, 16) zum Nachweis der von dem Elektronen konvertierenden Bereich (6, 23, 29) der Targetstruktur (5) emittierten Teilchen gegenüber der Targetstruktur (5) auf positiven Potential liegt.

9. Korpuskularstrahlgerät nach Anspruch 8, wobei das Nachweissystem (14, 15, 16) eine Elektrode, vorzugsweise eine Gitterelektrode (14) oder eine Lochblende aufweist.

10. Korpuskularstrahlgerät nach Anspruch 8 oder 9, wobei das Nachweissystem (14, 15, 16) außerhalb des Strahlführungsrohres (4) hinter einem Loch (26) durch die Wand des Strahlführungsrohres (4) oder im Bereich einer Unterbrechung des Strahlführungsrohres (4) angeordnet ist.

11. Korpuskularstrahlgerät nach einem der Ansprüche 5 - 10, wobei das elektrostatische Feld (E) und das/die magnetischen Felder (B1, B2) unabhängig voneinander einstellbar sind.

12. Korpuskularstrahlgerät nach einem der Ansprüche 5 - 11, wobei die Targetstruktur (5) auf dem Potential des Strahlführungsrohres (4) liegt.

## Claims

1. Detector system for a corpuscular beam apparatus, in particular a scanning electron microscope, with a target structure (5) to be arranged in the beam path, with the target structure (5) comprising a central axis-adjacent region (6, 23, 29), which is adjacent to the optical axis (25) of the corpuscular beam apparatus, and is composed of a material with a high conversion electron rate, and an axis-remote region (7, 24, 28); and with a detection system (14, 15, 16) for detecting the conversion electrons emitted by the electron conversion region (6, 23, 29), **characterized in that** the axis-remote region (28) is in the form of a half ring and the axis-adjacent region (29) is in the form of a web connecting the ends of the axis-remote region (28) which is in the form of a half ring.

2. Detector system for a corpuscular beam apparatus, in particular a scanning electron microscope, with a target structure (5) to be arranged in the beam path, with the target structure (5) comprising a central axis-adjacent region (6, 23, 29), which is adjacent to the optical axis (25) of the corpuscular beam apparatus, and is composed of a material with a high conversion electron rate, and an axis-remote region (7, 24, 28); and with a detection system (14, 15, 16) for detecting the conversion electrons emitted by the electron conversion region (6, 23, 29), with the target structure (5) being in the form of a flat screen, **characterized in that** the axis-remote region (24) is composed of a material with a low conversion electron rate.

3. Detector system for a corpuscular beam apparatus, in particular a scanning electron microscope, with a connected target structure (5) to be arranged in the beam path, with the target structure (5) comprising a central axis-adjacent region (6, 23, 29), which is adjacent to the optical axis (25) of the corpuscular beam apparatus, and is composed of a material with a high conversion electron rate which is arranged adjacent to an axis-remote region (7, 24, 28) via an intermediate region; and with a detection system (14, 15, 16) for detecting the conversion electrons emitted by the electron conversion region (6, 23, 29), in which the axis-remote region (7) is at a distance from the axis-adjacent region in the direction of the optical axis (25).

4. Corpuscular beam apparatus comprising a detector system according to one of Claims 1 - 3.

5. Corpuscular beam apparatus according to Claim 4, in which a deflection system, comprising an electrostatic deflection field (E) and a magnetic deflection field (B1, B2), is arranged upstream of the detector system (5, 6, 7, 8) in the direction of the corpuscles emerging from a compound (12), wherein the electrostatic deflection field (E) and the magnetic deflection field (B1, B2) are arranged perpendicular to one another.

6. Corpuscular beam apparatus according to Claim 5, in which the electrostatic deflection field (E) and the magnetic deflection field (B1, B2) are generated offset from one another along the direction of the optical axis (25) of the corpuscular beam apparatus.

7. Corpuscular beam apparatus according to Claim 6, in which two magnetic deflection fields (B1, B2) and one electrostatic deflection field (E) are provided.

8. Corpuscular beam apparatus according to one of Claims 5 - 7, in which the detection system (14, 15, 16) for detecting particles emitted by the electron conversion region (6, 23, 29) of the target structure (5) is at a positive potential compared to the target structure (5).

9. Corpuscular beam apparatus according to Claim 8, in which the detection system (14, 15, 16) comprises an electrode, preferably a grid electrode (14) or a perforated disc.

10. Corpuscular beam apparatus according to Claim 8 or 9, in which the detection system (14, 15, 16) is arranged outside the beam guide tube (4) behind a hole (26) through the wall of the beam guide tube (4), or in the region of an interruption in the beam guide tube (4).

11. Corpuscular beam apparatus according to one of Claims 5 - 10, in which the electrostatic field (E) and the magnetic field or fields (B1, B2) can be adjusted independently of one another.

12. Corpuscular beam apparatus according to one of Claims 5 - 11, wherein the target structure (5) is at the same potential as the beam guide tube (4).

## Revendications

1. Système détecteur pour un appareil à rayons corpusculaires, notamment un microscope électronique à balayage, comprenant une structure porteuse (5) à disposer dans le trajet de rayon, la structure porteuse (5) présentant une zone centrale proche de l'axe (6, 23, 29), voisine de l'axe optique (25) de l'appareil à rayons corpusculaires, en un matériau à forte conversion des électrons, ainsi qu'une zone éloignée de l'axe (7, 24, 28) et un système de détection (14, 15, 16) pour détecter les électrons de conversion émis par la zone (6, 23, 29) de conversion des électrons, **caractérisé en ce que** la zone éloignée de l'axe (28) est réalisée sous la forme d'un demi anneau et la zone proche de l'axe (29) sous la forme d'une nervure qui relie les extrémités de la zone éloignée de l'axe (28) en forme de demi anneau.

2. Système détecteur pour un appareil à rayons corpusculaires, notamment un microscope électronique à balayage, comprenant une structure porteuse (5) à disposer dans le trajet de rayon, la structure porteuse (5) présentant une zone centrale proche de l'axe (6, 23, 29), voisine de l'axe optique (25) de l'appareil à rayons corpusculaires, en un matériau à forte conversion des électrons, ainsi qu'une zone éloignée de l'axe (7, 24, 28) et un système de détection (14, 15, 16) pour détecter les électrons de conversion émis par la zone (6, 23, 29) de conversion des électrons, la structure porteuse (5) étant réalisée sous la forme d'un obturateur plan, **caractérisé en ce que** la zone éloignée de l'axe (24) se compose d'un matériau à faible conversion des électrons.

3. Système détecteur pour un appareil à rayons corpusculaires, notamment un microscope électronique à balayage, comprenant une structure porteuse (5) à disposer en continu dans le trajet de rayon, la structure porteuse (5) présentant une zone centrale proche de l'axe (6, 23, 29), voisine de l'axe optique (25) de l'appareil à rayons corpusculaires, en un matériau à forte conversion des électrons, laquelle est disposée par le biais d'une zone intermédiaire sur une zone éloignée de l'axe (7, 24, 28) et un système de détection (14, 15, 16) pour détecter les électrons de conversion émis par la zone (6, 23, 29) de conversion des électrons, la zone éloignée de l'axe (7) étant espacée par rapport à la zone proche de l'axe en direction de l'axe optique (25).

4. Appareil à rayons corpusculaires muni d'un système détecteur selon l'une des revendications 1 à 3.

5. Appareil à rayons corpusculaires selon la revendication 4, un système de déviation constitué d'un champ de déviation électrostatique (E) et d'un champ de déviation magnétique (B1, B2) étant monté en amont du système détecteur (5, 6, 7, 8) en direction des corpuscules qui sortent d'une préparation (12), le champ de déviation électrostatique (E) et le champ de déviation magnétique (B1, B2) étant perpendiculaires l'un à l'autre.

6. Appareil à rayons corpusculaires selon la revendication 5, le champ de déviation électrostatique (E) et le champ de déviation magnétique (B1, B2) étant générés décalés l'un par rapport à l'autre en direction de l'axe optique (25) de l'appareil à rayons corpusculaires.

7. Appareil à rayons corpusculaires selon la revendication 6, deux champs de déviation magnétiques (B1, B2) et un champ de déviation électrostatique (E) étant prévus.

8. Appareil à rayons corpusculaires selon l'une des revendications 5 à 7, le système de détection (14, 15, 16) destiné à détecter les particules émises par la zone (6, 23, 29) de conversion des électrons de la structure porteuse (5) se trouvant à un potentiel positif par rapport à la structure porteuse (5).

9. Appareil à rayons corpusculaires selon la revendication 8, le système de détection (14, 15, 16) présentant une électrode, de préférence une électrode en grille (14) ou un obturateur perforé.

10. Appareil à rayons corpusculaires selon la revendication 8 ou 9, le système de détection (14, 15, 16) étant disposé à l'extérieur du tube de guidage du rayon (4) derrière un trou (26) à travers la paroi du tube de guidage du rayon (4) ou dans la zone d'une interruption du tube de guidage du rayon (4).

11. Appareil à rayons corpusculaires selon l'une des revendications 5 à 10, le champ électrostatique (E) et le/les champs magnétiques (B1, B2) pouvant être réglés indépendamment les uns des autres.

12. Appareil à rayons corpusculaires selon l'une des revendications 5 à 11, la structure porteuse (5) se trouvant au potentiel du tube de guidage du rayon (4).
